Europäisches Patentamt

European Patent Office

Office européen des brevets

(11) Publication number : 0 567 265 A1

(19)

# (12) EUROPEAN PATENT APPLICATION

(21) Application number : 93302869.8

(22) Date of filing : 14.04.93

(51) Int. Cl.⁵ : $H03G\ 5/24$

(30) Priority : 15.02.93 JP 48598/93
24.04.92 JP 131697/92

(43) Date of publication of application :
27.10.93 Bulletin 93/43

(84) Designated Contracting States :
DE FR GB IT

(71) Applicant : HITACHI, LTD.
6, Kanda Surugadai 4-chome
Chiyoda-ku, Tokyo 101 (JP)

(71) Applicant : HITACHI MICROCOMPUTER
SYSTEM LTD.
5-22-1, Jousuihon-cho
Kodaira-shi, Tokyo 187 (JP)

(72) Inventor : Furuya, Tomio
1206-12 Fukushima, Tamamura-machi
Sawa-gun, Gunma (JP)
Inventor : Ienaka, Masanori
68-57 Shimano-machi
Takasaki-shi, Gunma (JP)

(74) Representative : Calderbank, Thomas Roger et
al
MEWBURN ELLIS 2 Cursitor Street
London EC4A 1BQ (GB)

(54) Radio receiver.

(57) An FM radio receiver which realizes high-fidelity reception without being affected by the modulation degree of a receiving station or by an adjacent station signal. A modulation degree detector circuit for monitoring the modulation degree of the demodulated audio signal of a desired station is used, and a filter network is so controlled as to change its band-pass characteristic to a wider pass-band characteristic when the modulation degree of the audio signal becomes deeper than a predetermined modulation degree. The pass-band width is broadened with the depth of the modulation degree of the receiving station signal irrespective of the interference level of the adjacent station signal.

FIG. 1

EP 0 567 265 A1

The present invention relates to a radio receiver and, particularly, to technology that can be effectively utilized for a demodulation system in e.g. an FM (frequency modulated) radio receiver of a band width switching system which employs an adaptive tracking system and a filter network.

There has been known an FM radio receiver of the type of double superheterodyne equipped with an adaptive tracking filter frequency demodulator circuit (a tracking function and a filter network function for automatically switching the filter band width) in the second intermediate-frequency amplifier stage. The adaptive tracking filter frequency demodulator circuit changes the center frequency of the second intermediate-frequency amplifier stage according to a change in the modulation degree of a broadcasted signal from a selected station, and further automatically changes the band width of the second intermediate-frequency amplifier means depending upon the strength of a signal from the selected station and the strength of the interference level of a broadcasted signal from a neighboring station, in order to decrease the interference by the broadcasted signal from the neighboring station.

The FM radio receiver equipped with the adaptive tracking filter frequency demodulator circuit is effective in receiving the signal from a desired station in such areas as European countries where broadcasting stations are located close to one another. Furthermore, the portable receivers and the car-mounted receivers are often interfered by radio waves from remove broadcasting towers while the receivers are moving in mountaneous terrains. However, the above-mentioned FM radio receiver exhibits great effects even in such circumstances.

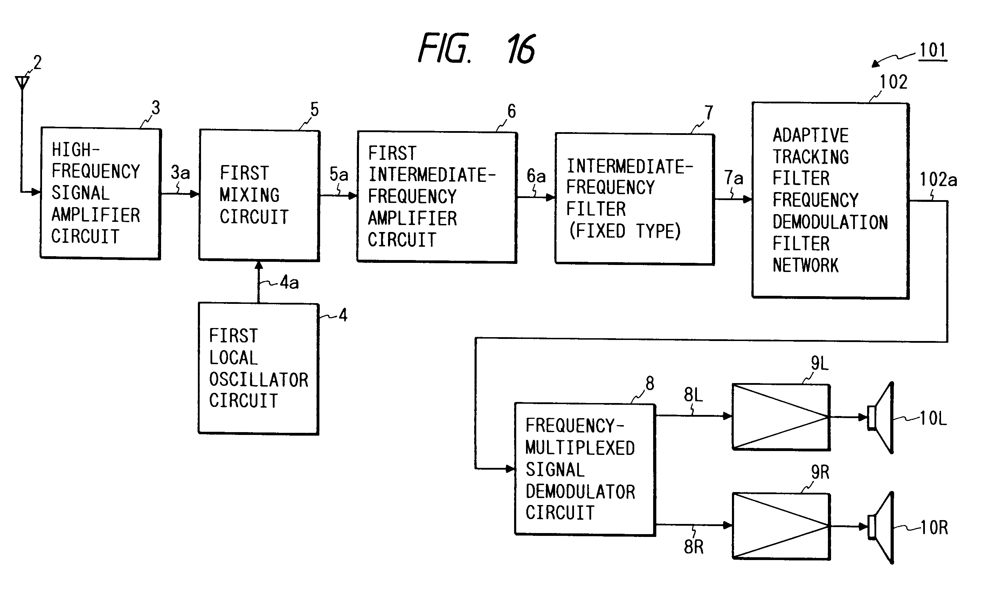

Fig. 16 is a block diagram illustrating the whole of an FM radio receiver of the type of double superheterodyne, known before the present invention and equipped with an adaptive tracking filter frequency demodulator circuit in the second intermediate-frequency amplifier stage. Such an FM radio receiver has been disclosed in, for example, Japanese Patent Application No. 180246/1991.

In an FM radio receiver 101 known before the present invention, a broadcasted signal (frequency-modulated signal) received by a receiving antenna 2 is amplified through a high-frequency signal amplifier circuit 3, and an output signal 3a thereof and a first local oscillation frequency signal 4a generated by a first local oscillation circuit 4 are mixed together through a first mixing circuit 5 in order to form a first intermediate-frequency signal 5a of, for example, 10.7 MHz. This signal 5a is amplified through a first intermediate-frequency amplifier circuit 6. The amplifier output signal 6a is fed to an intermediate-frequency filter 7 of the pass-band fixed type which has a predetermined frequency band width. A first intermediate-frequency output signal 7a that has passed through the intermediate-frequency filter 7 is fed to an adaptive tracking filter frequency demodulator circuit 102.

The demodulated output 102a of the adaptive tracking filter frequency demodulator circuit 102 is input to a frequency-multiplexed signal demodulator circuit 8 such as a stereo signal demodulator circuit or a like circuit. In the case of a stereo broadcasted signal, the signal is demodulated into voice signals 8L and 8R of left and right two channels. In the case of the frequency-division multiplex broadcast, traffic information broadcasted on a sub-channel, information related to the identification code of a broadcasting station, and the broadcast on the main channel are switched by a signal selection circuit that is not shown, and the voice signals 8L, 8R (sometimes includes digital signals) are power-amplified through low-frequency amplifier units 9L and 9R to drive electroacoustic transducers 10L, 10R such as speakers and thereby to reproduce audible sound. The voice signals, 8L, 8R can be fed to other devices from an output unit that is not shown.

The FM radio receiver 101 of the superheterodyne type of the prior art is so constituted as to narrow the pass-band of signals according to the strength of the broadcasted signal from the receiving station and to the strength of the broadcasted signal from a neighboring station by using the second intermediate-frequency amplifier stage and thereby to improve the selectivity. Therefore, when a deeply frequency-modulated signal is received in a state where the signal of the neighboring station is detected by a neighboring station signal level detector circuit and hence the pass-band of the second intermediate-frequency amplifier stage is narrowed by the filter pass-band control circuit, the signal is greatly distorted due to the limitation on the pass-band of the filter. The quality of sound is substantially improved with an increase in the depth of frequency modulation, deep modulation is widely adopted in some European countries. In particular, local European FM broadcasting stations generally employs excess degree of modulation which is far beyond those of the broadcasting practice in Japan.

When overmodulated signals are received under the above-mentioned narrow band condition, the AM components in the second intermediate-frequency amplifier stage increase. The AM components in the output signals of an envelope detector circuit in an AGC circuit increase, too. Therefore, the output of the circuit for picking up signals from the neighboring station increases, narrowing the pass-band width of the filter. As a result, the band width of the tracking filter circuit becomes no more capable of following up the frequency modulation, resulting in an increase in distortion and noise in the demodulated signals. Moreover, since a mute detecting circuit is detecting the lower side of the envelope circuit, an increase in the AM components in the second intermediate-frequency amplifier stage lowers the level of the output signal of the mute detector circuit, whereby the muting circuit is turned on, lowering the output signal.

It is therefore an object of the present invention to provide an FM radio receiver which makes it possible to achieve high fidelity signal reception and reproduce the broadcasted signals of a receiving station without being affected by the degree of modulation of broadcasted signals of the receiving station and/or by the broadcasted signals from the neighboring stations.

The above and other objects and novel features of the present invention will become obvious from the description of the specification and the accompanying drawings.

Among the inventions disclosed in this application, a typical one will be briefly described below. That is, a radio receiver comprises a demodulator means (12) including a tracking filter (24) capable of switching a passband width, a filter control means (34) which controls the pass-band width of the tracking filter according to the strength of the electric field of the signal from a desired station and to the strength of the electric field of the signal from a neighboring station, and control circuits (11, 30, 31, 37, 38, 32) for controlling the operation of the filter control means.

The above control means includes a modulation degree detector circuit (11) and/or a multi-pass detector circuit (37). The operation of the filter control means (34) is controlled by utilizing the output signal of the modulation degree detector circuit (11) and/or by the output signal of the multi-pass detector circuit (37).

As a result, the pass-band width of the tracking filter becomes wider or the widest when the modulation degree of broadcasted signals from a desired station becomes greater than a predetermined modulation degree and/or when the output signal of the multi-pass detector circuit (37) becomes greater than a predetermined value.

Accordingly, the pass-band width of the tracking filter can be widened without being affected by the interference level of the neighboring station even if the broadcasted signals of the receiving station have a deep modulation degree or the output signal of the multi-pass detector has a large value. Therefore, the broadcasted signals of the receiving station can be reproduced with a high fidelity.

In the drawings

Fig. 1 is a block diagram illustrating the whole of an FM radio receiver of the double superheterodyne system equipped with an adaptive tracking filter frequency demodulator circuit in the second intermediate-frequency amplifier stage of an embodiment according to the present invention;

Fig. 2 is a block diagram illustrating the adaptive tracking filter frequency demodulator circuit of an embodiment of the present invention;

Fig. 3 is a diagram illustrating variable pass-band characteristics of a tracking filter circuit which is the second intermediate-frequency filter;

Fig. 4 is a level diagram showing pass-band selection characteristics of a filter pass-band control circuit according to the present invention;

Fig. 5 is a characteristic diagram of a low-pass filter used for a modulation degree detector circuit;

Fig. 6 is a diagram of waveforms for explaining the operation of the modulation degree detector circuit;

Fig. 7 is a diagram of timings for explaining the operation of a holding circuit provided in the modulation degree detector circuit;

Fig. 8 is a block diagram illustrating an example of the tracking filter circuit;

Fig. 9 is a diagram of frequency characteristics of filter circuits of each of the stages constituting the tracking filter;

Fig. 10 is a diagram illustrating examples of an interfering station signal level detector circuit and a gate circuit;

Fig. 11 is a block diagram illustrating another embodiment of the adaptive tracking filter frequency modulator circuit according to the present invention;

Fig. 12 is a block diagram showing an example of the high-pass filter of Fig. 11;

Fig. 13 is a diagram of frequency characteristics of the high-pass filter of Fig. 12;

Fig. 14 is a block diagram illustrating still another embodiment of the adaptive tracking filter frequency demodulator circuit according to the present invention;

Fig. 15 is a block diagram illustrating an example of the adaptive tracking filter frequency demodulator circuit according to the present invention; and

Fig. 16 is a block diagram illustrating the whole of an example of a conventional FM radio receiver of a double superheterodyne system equipped with an adaptive tracking filter frequency demodulator circuit in the second intermediate-frequency amplifier stage.

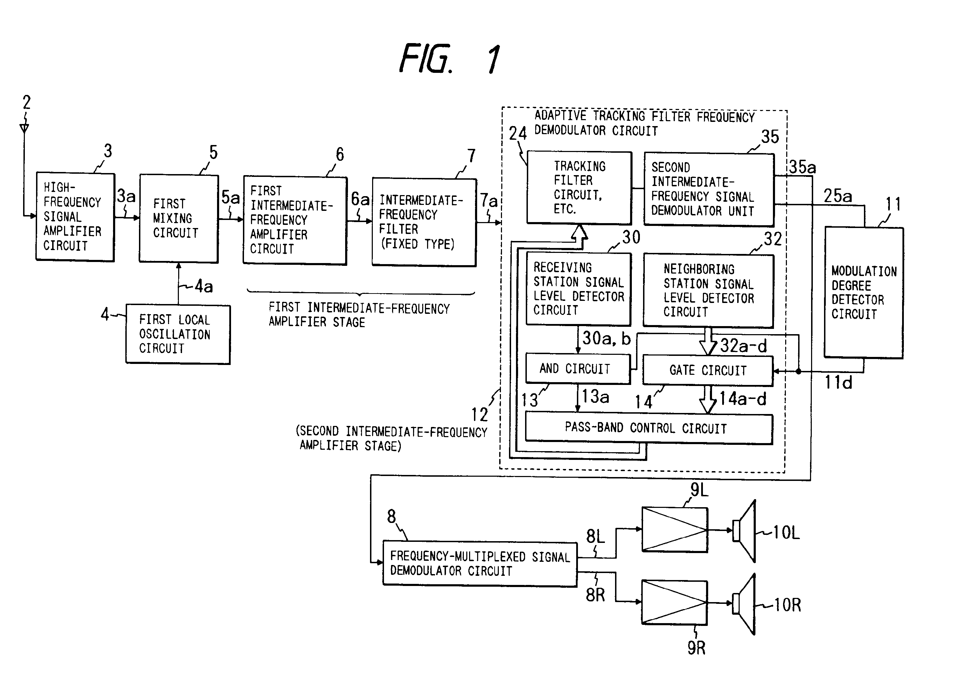

Fig. 1 is a block diagram illustrating the whole of an FM radio receiver of a double superheterodyne system equipped with an adaptive tracking filter frequency demodulator (frequency modulation) circuit in the second intermediate-frequency stage according to the present invention.

A frequency-modulated signal received by a receiving antenna 2 is amplified through a high-frequency sig-

3

nal amplifier circuit 3, and the output signal 3a thereof and a first local oscillation frequency signal 4a generated by a first local oscillation circuit 4 are mixed together through a first mixing circuit 5 in order to produce a first intermediate-frequency signal 5a of, for example, 10.7 MHz. This signal 5a is amplified through a first intermediate-frequency amplifier circuit 6. The amplified output signal 6a is fed to an intermediate-frequency filter 7 of the pass-band fixed type which has a predetermined frequency band width. A first intermediate-frequency output signal 7a that has passed through the intermediate-frequency filter 7 is fed to a frequency demodulator circuit 12 which includes an adaptive tracking filter. The frequency demodulator circuit 12 is newly provided with an AND circuit 13 and a gate circuit 14, and restricts the control input signal inputted to the pass-band control circuit according to the detection signal of the modulation depth of the audio signal by a modulation degree detector circuit 11 that is newly added.

The demodulated output 35a of a second intermediate-frequency signal demodulator unit 35 in the adaptive tracking filter frequency demodulator circuit 12 is input to a frequency-multiplexed signal demodulator circuit 8 such as a stereo signal demodulator circuit or a like circuit. In the case of a stereo broadcasted signal, the signal is demodulated into voice signals 8L and 8R of left and right two channels. In the case of the frequency-division multiplex broadcast, traffic information broadcasted on a sub-channel, information related to identification code of a broadcasting station, and the broadcast on the main channel are switched by a signal selection circuit that is not shown, and the voice signals 8L, 8R (often includes digital signals) are power-amplified through low-frequency amplifier units 9L and 9R to drive electroacoustic transducers 10L, 10R such as speakers and thereby to reproduce audible sound. The voice signals 8L, 8R can be fed to other devices from an output unit that is not shown.

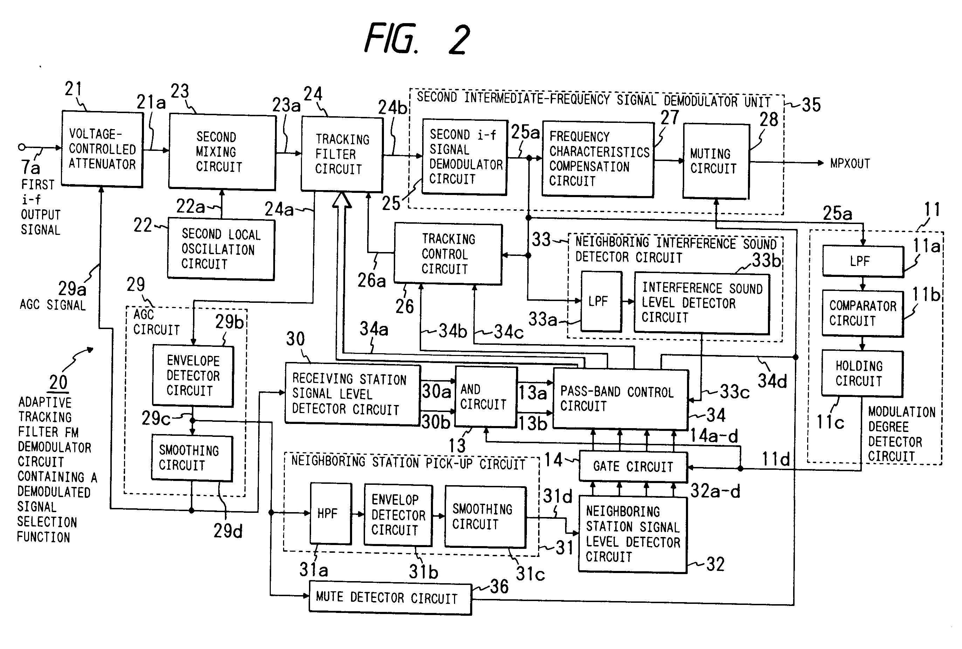

Fig. 2 is a block diagram illustrating the adaptive tracking filter frequency demodulator circuit 12 of the embodiment according to the present invention. The adaptive tracking filter frequency demodulator circuit 20 of this embodiment is equipped with a voltage-controlled attenuator 21, a second local oscillation circuit 22, a second mixing circuit 23, a tracking filter circuit 24, a second intermediate-frequency signal demodulator circuit 25, a tracking control circuit 26, a frequency characteristic compensation circuit 27, a muting circuit 28, an auto gain control (AGC) circuit 29, a receiving station signal level detector circuit 30, a neighboring station pick-up circuit 31, a neighboring station signal level detector circuit 32, a neighboring interference sound detector circuit 33, a filter pass-band control circuit 34, a muting circuit 35, a modulation degree detector circuit 11, an AND circuit 13 and a gate circuit 14.

The voltage-controlled attenuator 21 is so constituted as to change the amount of attenuation according to an AGC signal 29a outputted from the AGC circuit 29, and so operates as to keep at nearly a constant level the first intermediate-frequency signal 21a that is fed to the second mixing circuit 23.

The second local oscillation circuit 22 generates a second local oscillation frequency signal 22a of a frequency of, for example, 10 MHz and feeds it to the second mixing circuit 23, which mixes the first intermediate-frequency signal 21a and the second local oscillation frequency signal 22a together to produce a second intermediate-frequency signal 23a having an intermediate frequency of, for example, 700 kHz. The second intermediate-frequency signal 23a is input to the tracking filter circuit 24 that will be described below.

The tracking filter circuit 24 has a function of continuously changing the center frequency of the filter and a function of switching the pass-band width with respect to the center frequency at, for example, six steps. The center frequency of the filter is changed by changing the capacitances of a plurality of variable capacitance diodes in the filter circuit according to a tracking control voltage 26a for controlling the center frequency outputted from the tracking control circuit 26.

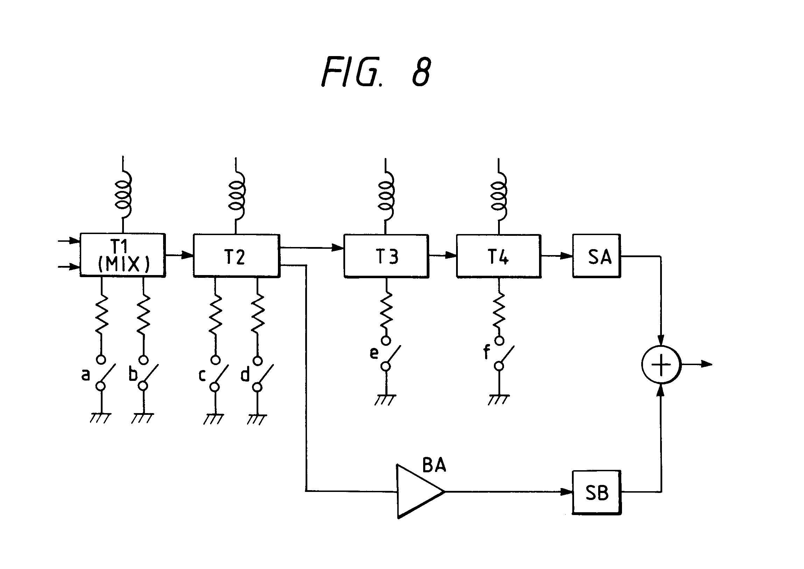

The pass-band width is switched by changing the resistance of a selectivity-adjusting resistor (damping resistor) that is connected in parallel with a coil in the filter circuit, which will be described later, according to pass-band specifying information 34a (e.g., information consisting of five parallel bits) outputted from the filter pass-band control circuit 34 (see Fig. 8).

The tracking filter circuit unit 24 has four filter circuits connected in series. The tracking of the center frequency is controlled chiefly by the filter circuits of the first two stages, and the pass-band width is switched chiefly by the filter circuits of the second two stages.

The filter pass-band control circuit 34 outputs a control signal for causing the signal having passed through the first two stages to be outputted from a terminal 24a, and for changing the pass-band width of the tracking filter circuit 24 so as to select a signal to be outputted from a terminal 24b, from among the two signals, a signal having passed through both the first two stages and the second two stages of the tracking filter circuit 24, and a signal having passed through only the first two stages, based on the number-of-filter-stages specifying information included in pass-band specifying information 30b, 32a-d produced by the receiving station signal level detector circuit 30 and the neighboring station signal level detector circuit 32.

The second intermediate-frequency signal demodulator unit 25 demodulates the signal outputted from the output terminal 24b of the tracking filter circuit 24. The demodulated detection output 25a is fed to the tracking control circuit 26, frequency characteristics compensation circuit 27 and neighboring interference sound detector circuit 33. Here, the second intermediate-frequency demodulation means demodulating the second intermediate-frequency signals but does not mean the second demodulation.

The tracking control circuit 26 is so constituted as to select its operation mode from a tracking voltage mode in which the tracking control voltage is changed according to the detection output 25a and a tracking stop mode for outputting a predetermined fixed DC voltage related to designating the center frequency of the filter, in response to a tracking on/off control signal 34d.

In the tracking operation mode, the tracking control circuit 26 changes the range in which the center frequency of the filter can be changed according to the detection output 25a into a wide range of frequencies or into a relatively narrow range of frequencies according to a tracking range changing signal 34c. The tracking range is changed by adjusting the gain of a feedback control loop according to the tracking range changing signal 34c.

The frequency characteristics compensation circuit 27 is equipped with a peaking circuit which emphasizes high-pass components of the detection output 25a of the second intermediate-frequency signal whose band is narrowed by using the tracking filter circuit 24, and emphasizes high-pass components of the main-channel signals and the subchannel signals. The peaking frequency may generally be the one of the subcarrier waves (67 kHz in the U.S.A., 57 kHz in European countries, 38 kHz in Japanese stereo broadcasting, etc.).

The detection output 27a of which the frequency characteristics are compensated is outputted as a multiplexed output signal (MPXOUT) via a muting circuit 28 which limits the magnitude of the output signal based on a muting signal 34d.

The AGC circuit 29 is equipped with an envelope detector circuit 29b which detects the envelope of the second intermediate-frequency signals of a relatively wide band outputted from the intermediate output terminal 24a of the tracking filter circuit 24, and a smoothing circuit 29d which smoothes an envelope detection output 29c with a predetermined time constant to produce an AGC signal 29a, which will be fed to the voltage-controlled attenuator 21 and to the receiving station signal level detector circuit 30. The envelope detection output 29c is fed to the neighboring station signal pick-up circuit 31 and to the mute detector circuit 35.

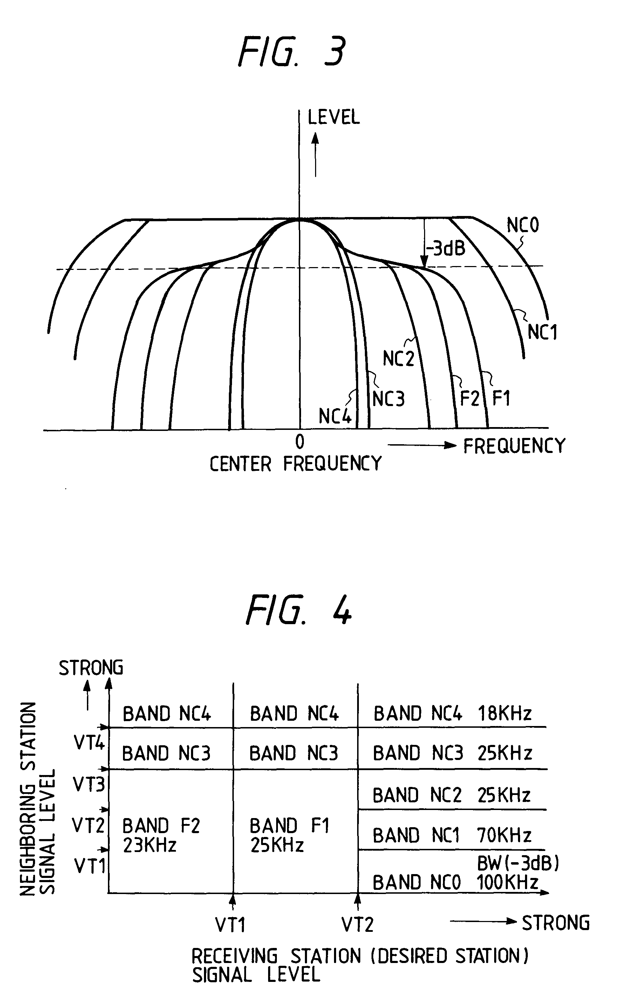

The receiving station level detector circuit 30 generates information 30a, 30b on the magnitude of the receiving level of the signal of a receiving station (desired station) based on the AGC signal 29a, and feeds them to the pass-band control circuit 34 via an AND circuit 13 that will be described later. For instance, the receiving station level detector circuit 30 is equipped with two different voltage comparator circuits having different threshold voltages VT1 and VT2, which output information 30a, 30b related to the magnitude of reception level of the comparison outputs, in order to divide the level of the received signals into three steps, large, medium and small (see Fig. 4).

The neighboring station signal pick-up circuit 31 is equipped with a high-pass filter (HPF) 31a, an envelope detector circuit 31b, and a smoothing circuit 31c. The neighboring station signal pick-up circuit 31 outputs an AM signal produced by the interference between the receiving station signal and the neighboring station signal included in the detection output 29c of the envelope detector circuit 29b in the AGC circuit 29. The interference signal is extracted as a differential signal between the receiving station signal and the neighboring station signal via a high-pass filter 31a, the envelope of the high-pass component that is extracted is detected again through the envelope detector circuit 31d and is smoothed by the smoothing circuit 31c. Thus, the interference signal is outputted as a voltage 31d that corresponds to the level of a signal of a station whose channel is adjacent to the receiving station (desired station).

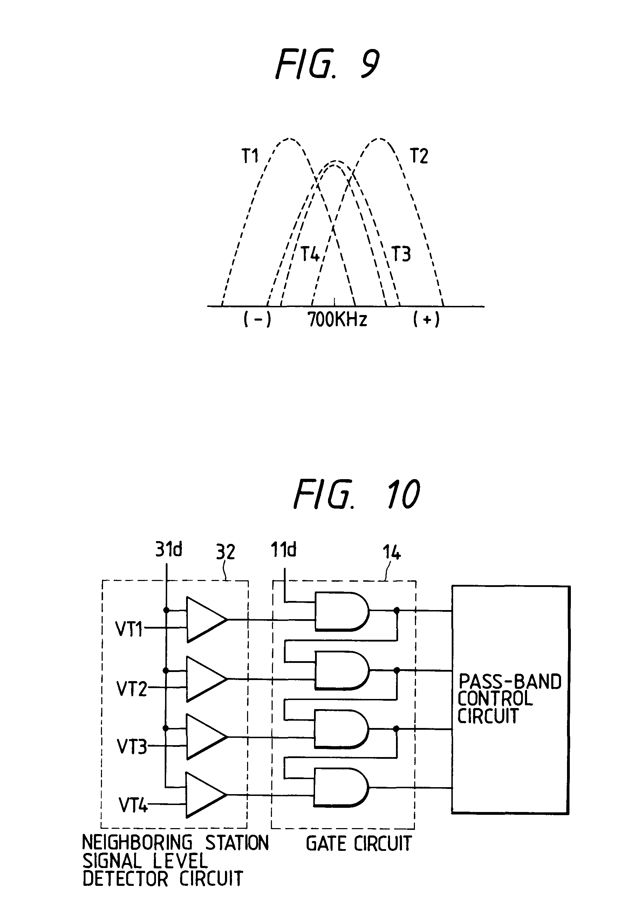

The neighboring station level detector circuit 32 feeds information 32a, 32b, 32c, 32d (abbreviated to 32a-d in the drawings) on the magnitude of the reception level of the neighboring station to the pass-band control circuit 34 via the gate circuit 14 that will be described later according to a voltage output 31d fed from the neighboring station signal pick-up circuit 31. The neighboring station level detector circuit 32 is equipped with, for example, four different voltage comparator circuits having threshold voltages VT1 to VT4, which produce comparison outputs as information 32a-d on the magnitude of the interference signal level, in order to divide the level of the interference signal by the neighboring station into five steps (see Figs. 4 and 10).

The neighboring interference sound detector circuit 33 includes a low-pass filter (LPF) 33a which passes low-frequency components included in the detect output 25a demodulated by the second intermediate-frequency signal demodulator circuit 25, and an interference sound detector circuit 33b which generates a logic output 33c related to neighboring interference detection when the output of the low-pass filter 33a has exceeded a predetermined threshold level. The interference sound detector circuit 33b is constituted by a voltage comparator which has a predetermined threshold voltage. The interference sound detect output 33c is fed to the pass-band control circuit 34.

The pass-band control circuit 34 receives, as its control input, information 30a, 30b on the magnitude of a signal level of the receiving station (desired station), information 32a-d related to (interference) signal of the neighboring station and the neighboring interference sound detect output 33c, and outputs information 34a for designating the pass-band of the tracking filter circuit 24, a signal 34b for instructing ON/OFF of the tracking operation, and a signal 34c for changing the tracking range, under predetermined conditions.

Fig. 3 is a diagram of variable pass-band characteristics of an example of the tracking filter circuit 24 which is the second intermediate-frequency filter. The tracking filter circuit 24 of this embodiment is capable of selecting the pass-band width from seven steps NC0 to NC4, F1 and F2 according to a filter pass-band designation data 34a.

Fig. 4 is a diagram of the pass-band selection characteristic of an example of the filter pass-band control circuit 34 of the embodiment. As shown in Fig. 4, the filter pass-band control circuit 34 selects the pass-band of the second intermediate-frequency signals from seven bands, i.e., NC0 to NC4, F1 and F2 based on the combination of three steps discriminated by the threshold voltages VT1 and VT2 of signal levels (electric field strengths) of the receiving station (desired station) and five steps that correspond to interference wave levels (electric field strengths of interference waves) from the neighboring station.

Being constituted as described above, the first intermediate-frequency amplifier stage (consisting of a first intermediate-frequency amplifier unit 6 and an intermediate-frequency filter 7 of a fixed type) selects a relatively wide predetermined band, and the tracking filter circuit which is the second intermediate-frequency amplifier stage narrows the pass-band width according to the degree of neighbor interference, in order to greatly reduce the radio interference by the neighboring station signal.

In this embodiment, there are added a modulation degree detector circuit 11, an AND circuit 13 and a gate circuit 14 in order to realize signal reception of high fidelity without being affected by the degree of modulation of the receiving station signal or by the neighboring station signal.

That is, the tracking filter frequency modulator circuit equipped with the modulation degree detector circuit 11, AND circuit 13 and gate circuit 14, controls the transmission of detection outputs 30a, 30b and 32a-d of the receiving station signal level detector circuit 30 and the neighboring station signal level detector circuit 32 that control the pass-band.

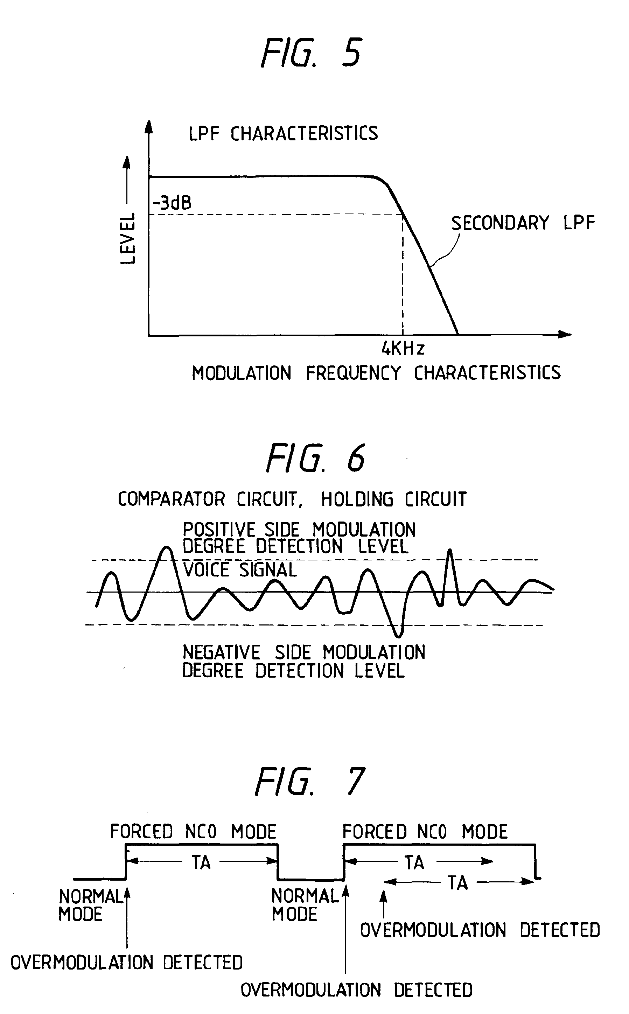

The modulation degree detector circuit 11 is constituted by a low-pass filter (LPF) 11a which receives the detection output 25a, a comparator circuit 11b and a holding circuit 11c. Fig. 5 is a diagram illustrating the characteristics of the low-pass filter 11a which has such secondary LPF characteristics that the level -3 dB corresponds to the frequency 4 kHz. The degree of modulation changes at all times during the broadcasting. Therefore, when the degree of modulation exceeds the positive side modulation degree detection level or the negative side modulation degree detection level as shown in a waveform diagram of Fig. 6, the voltage comparator circuit detects this fact and controls the holding circuit 11c. When the holding circuit 7 receives an overmodulation detect signal, as shown in Fig. 7, the holding circuit 7 holds the detection signal 11d for a given period of time TA to restrict the band from being narrowed, and forces the gate circuit 14 and the AND circuit to operate in the NC0 mode. When the overmodulation is detected again within the holding time TA, the holding time is lengthened by a time TA from the moment of detection.

The gate circuit 14 is controlled by the signal 11d to set, by the control signals 14a-d inputted to the pass-band control circuit 34, equivalently the level of the neighboring station signal to a minimum value which is lower than the VT1 of Fig. 4 irrespective of detection outputs 32a-d of the neighboring station signal level detector circuit 32. The AND circuit 13 is controlled by the signal 11d to equivalently set, by means of the control signals 13a, 13b inputted to the pass-band control circuit 34, the level of the receiving station signal to a maximum value greater than the VT2 of Fig. 4 irrespective of the detection outputs 30a, 30b of the receiving station signal level detector circuit 30. Therefore, when the overmodulated condition is detected by the modulation degree detector circuit 11, the tracking filter circuit 24 is operated in the NC0 mode of the broadest band irrespective of the level of the receiving station signal or the level of the interfering station signal. By this, the distortion of signals at the time of overmodulation is reduced, and the high fidelity reception of broadcasting can be achieved.

Fig. 8 is a block diagram illustrating an example of the tracking filter circuit. Filter circuits using tank circuits T1 to T4 are connected in a cascade form. The tracking of the center frequency is chiefly controlled by the tank circuits T1 and T2 of the first two stages, and the pass-band width is changed chiefly by the tank circuits T3 and T4 of the second two stages. The tank circuit T1 also serves as a mixing circuit MIX.

To the tank circuit T1 are connected resistors when the switches a and b are turned on. To the tank circuit T2 are connected resistors when the switches c and d are turned on. To the tank circuit T3 of the next stage is connected a resistor when a switch e is turned on. To the tank circuit T4 is connected a resistor when a switch f is turned on.

The output signals of the filter circuits of the first two stages are sent to the filter circuits of the second two stages and are further inputted to a switch SB via a buffer circuit BA. The output signals of the filter circuits of the second stage are inputted to a switch SA. The output signals of the switches SA and SB are outputted via an adder circuit.

In order to obtain the pass-band characteristics of Fig. 4, the switches a to f, SA and SB are controlled as shown in Table 1 below wherein "ON" represents the ON-state and no mark represents the OFF-state. Symbol "-" represents ineffectiveness (the switches can be either in ON-state or in OFF-state).

Table 1

| Band/Switch | a | b | c | d | e | f | SA | SB |
|---|---|---|---|---|---|---|---|---|
| NC0 | ON | ON | ON | ON | - | - | | ON |
| NC1 | ON | | ON | | | | | ON |
| NC2 | | | | | ON | ON | ON | ON |
| NC3 | | | | | ON | ON | ON | |
| NC4 | | | | | | | ON | |
| F1 | ON | | ON | | ON | ON | ON | ON |
| F2 | ON | | ON | | | | ON | ON |

Fig. 9 is a diagram showing frequency characteristics of the filter circuits of each of the stages. Using the combinations of the characteristics T1 to T4 pass-band characteristics as shown in Fig. 3 can be obtained. Basically, the band characteristics of NC0 and NC1 are obtained by using characteristics of the filter circuits T1 and T2 of the first two stages (the switch SB is turned on). The band characteristics of NC2, F1 and F2 are obtained by the combinations of both the first two stages and the second two stages (switches SA and SB are turned on).

That is, as described above, the signal that has passed through the filter circuits T1 and T2 of the first two stages is outputted from the terminal 24a to use it for AGC control, extraction of the neighboring station signal and detection of the muting. Moreover, the switches a to f, SA and SB are changed based upon filter stage number designation information included in the pass-band designation information 30b, 32a-d created by the receiving station signal level detector circuit 30 and the neighboring station signal level detector circuit 32 in order that the output signal to be sent to the demodulator circuit of the next stage is selected from two signals: a signal having passed through the filter circuits of both the first two stages and the second two stages; and a signal having passed through the filter circuit of only the first two stages.

Fig. 10 is a circuit diagram of examples of the neighboring station signal level detector circuit 32 and the gate circuit 14. The neighboring station signal level detector circuit 32 is constituted by four stages of comparators having threshold voltages VT1 to VT4. The voltage output 31d fed from the neighboring station signal pick-up circuit 31 is inputted into the comparators where its level is determined. The information on the magnitude of the reception level of the neighboring station signal is fed to the next gate circuit 14.

The gate circuit 14 is constituted by AND gate circuits. In this embodiment, an AND gate circuit is provided even for a level decision output that corresponds to the lowest threshold voltage VT1, and a modulation degree detection signal 11d is inputted into the control input. The output signal of this AND gate circuit is used as a control signal for an AND gate circuit that receives the level decision output that corresponds to the next lowest threshold voltage VT2. Similarly, the others AND gate circuits are connected in series.

The AND gate circuits connected as described above prevents erroneous operation. That is, only when the level decision output corresponding to the VT1 is at the high level, it is permitted to output the high level that corresponds to the VT2 which is higher than the VT1. Similarly, hereinafter, the level decision output of the high level is outputted provided the decision level corresponding to a lower threshold voltage is the high level.

With the signal 11d being at the low level, it is allowed to render all of the output signals of the AND gate circuits connected in series to be at the low level irrespective of the level decision output. In other words, the signal 11d makes it possible to forcedly equalize the neighboring interference signal level to be lower than the VT1.

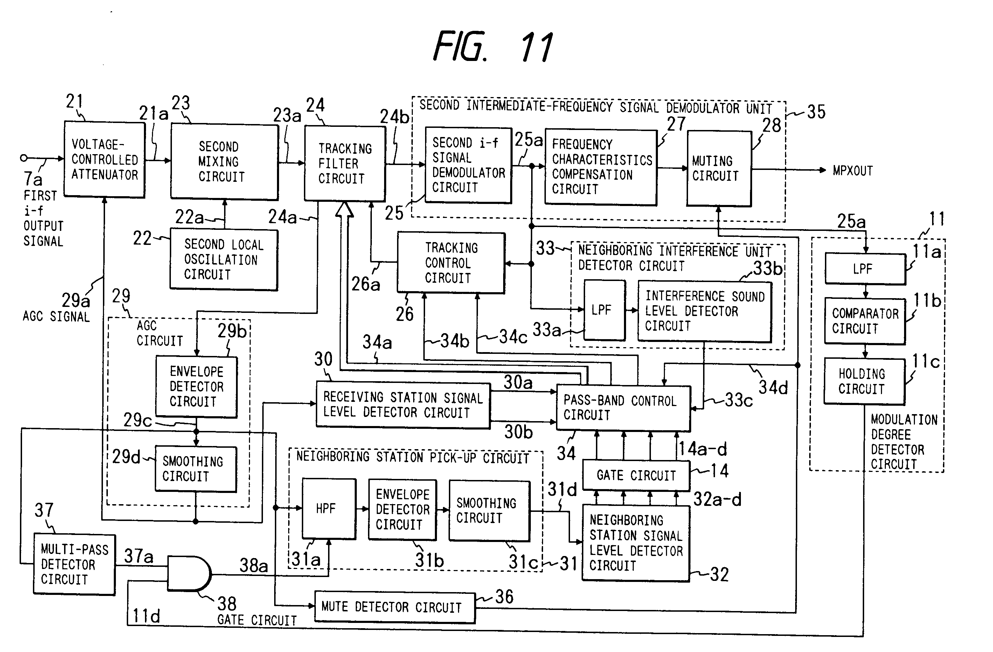

Fig. 11 is a block diagram of another embodiment of an adaptive tracking filter frequency demodulator circuit according to the present invention. In this embodiment, the adaptive tracking filter frequency demodulator circuit 20 is equipped with a voltage-controlled attenuator 21, a second local oscillation circuit 22, a second mixer circuit 23, a tracking filter circuit 24, a second intermediate-frequency signal demodulator circuit 25, a tracking control circuit 26, a frequency characteristics compensation circuit 27, a muting circuit 28, an AGC circuit 29, a receiving station signal level detector circuit 30, a neighboring station pick-up circuit 31, a neighboring station signal level detector circuit 32, a neighboring interference detector circuit 33, a filter pass-band control circuit 34, a muting circuit 35, a modulation degree detector circuit 11, a multi-pass detector circuit 37 and a gate circuit 38. The neighboring station pick-up circuit 31 includes a variable high-pass filter HPF.

When compared with the embodiment of Fig. 2, the gate circuit 14 provided in the input unit of the pass-band control circuit does not have an AND gate circuit that corresponds to the lowest threshold voltage of Fig. 10 but has the others AND gate circuits in order to prevent erroneous operation. The AND circuit 13 that corresponds to the receiving station signal level detector circuit 30 is omitted.

The multi-pass detector circuit detects the phase difference between a frequency-modulated signal of a desired station and the reflected wave of the frequency-modulated signal, and is constituted by a circuit for determining the level of the signal which is a predetermined frequency component extracted from the output signal 29c of the envelope detector circuit 29b in the AGC circuit 29 and smoothed. When the output signal of the multi-pass detector circuit is greater than a predetermined value and modulated deeply, the output 38a of the AND gate 38 goes to the high level, whereby the cut-off frequency of the high-pass filter HPF is switched to a higher side. In other words, the sensitivity of picking-up neighboring station signal interference is lowered to equivalently lower the neighboring station interference signal level. This makes it possible to realize the reproduction of high fidelity like that of the embodiment of Fig. 2. Though there is no particular limitation, the multi-pass detector circuit is separately formed of a semiconductor integrated circuit.

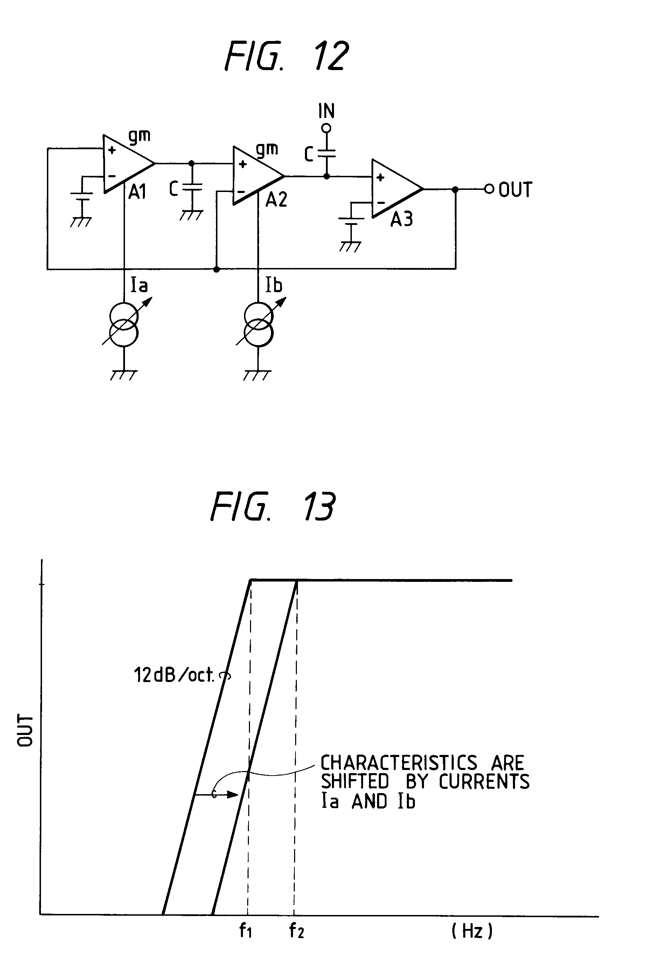

Fig. 12 is a block diagram of an example of a variable high-pass filter HPF. Here, the conductances gm's of the amplifier circuits A1 and A2 that constitute the high-pass filter is variable by varying the operation currents Ia and Ib, and time constants with the capacitors C are varied in order to change the cut-off frequency.

Fig. 13 illustrates frequency characteristics of the variable high-pass filter of Fig. 12. The operation currents Ia and Ib of the variable high-pass filter can be set to any desired values by means of resistor elements externally provided and not shown. Moreover, the amount of change in the cut-off frequency can be set to any desired value by a resistor element externally provided. That is, the cut-off frequencies $f_1$ and $f_2$ shown in Fig. 13 can be set to any values.

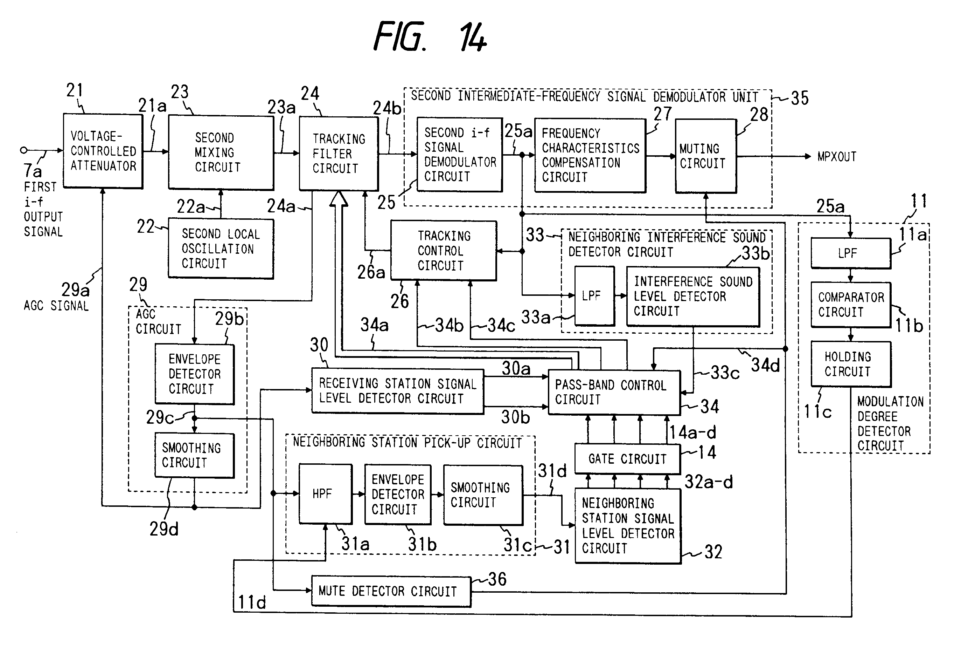

Fig. 14 is a block diagram of another embodiment of an adaptive tracking filter frequency demodulator circuit according to the present invention. In this embodiment, the adaptive tracking filter frequency demodulator circuit 20 is provided with a voltage-controlled attenuator 21, a second local oscillation circuit 22, a second mixing circuit 23, a tracking filter circuit 24, a second intermediate-frequency signal demodulator circuit 25, a tracking control circuit 26, a frequency characteristics compensation circuit 27, a muting circuit 28, an AGC circuit 29, a receiving station signal level detector circuit 30, a neighboring station pick-up circuit 31, a neighboring station signal level detector circuit 32, a neighboring interference detector circuit 33, a filter pass-band control circuit 34, a muting circuit 35, and a modulation degree detector circuit 11. The neighboring station pick-up circuit 31 includes a variable high-pass filter HPF. The difference of the embodiment of Fig. 14 from that of Fig. 11 is that the characteristics of the high-pass filter HPF are variably controlled directly by the output 11d of the modulation degree detector circuit 11.

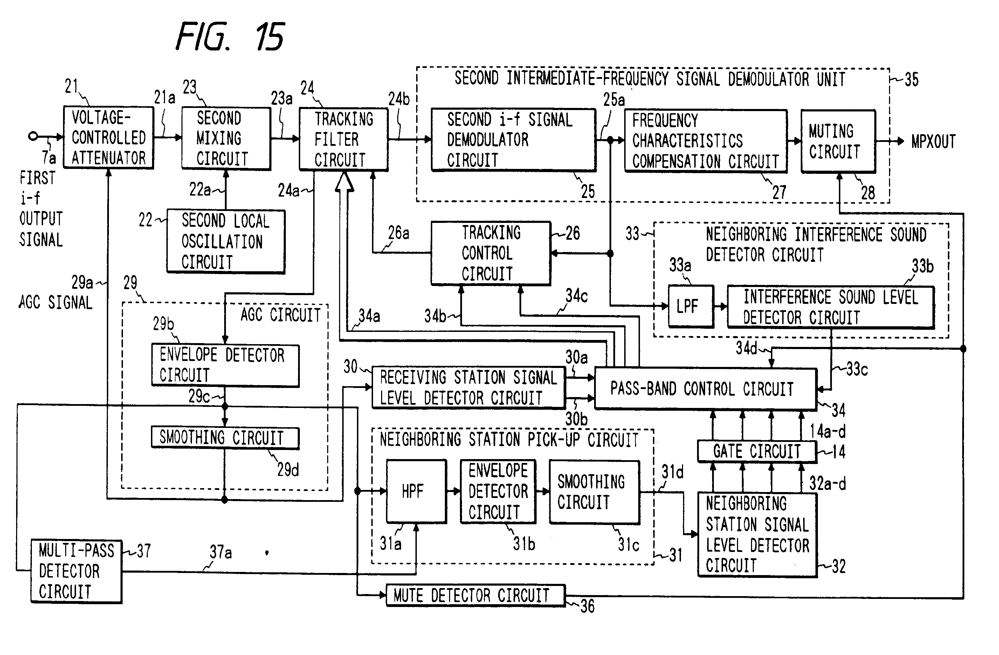

Fig. 15 is a block diagram of a still further embodiment of an adaptive tracking filter frequency demodulator circuit according to the present invention. In this embodiment, the adaptive tracking filter frequency demodulator circuit 20 is equipped with a voltage-controlled attenuator 21, a second local oscillation circuit 22, a second mixing circuit 23, a tracking filter circuit 24, a second intermediate-frequency signal demodulator circuit 25, a tracking control circuit 26, a frequency characteristics compensation circuit 27, a muting circuit 28, an AGC circuit 29, a receiving station signal level detector circuit 30, a neighboring station pick-up circuit 31, a neighboring station signal level detector circuit 32, a neighboring interference detector circuit 33, a filter pass-band control circuit 34, a muting circuit 35, and a multi-pass detector circuit 37. The neighboring station pick-up circuit 31 includes a variable high-pass filter HPF. The difference of the embodiment of Fig. 15 from that of Fig. 11 is that the characteristics of the high-pass filter HPF are variably controlled directly by the output 37a of the multi-pass detector circuit 37.

In Figs. 14 and 15, the constitution and characteristics of the high-pass filter HPF can be equivalent to those shown in Figs. 12 and 13. By the adaptive tracking filter frequency modulator circuit constituted as shown in Figs. 14 and 15, the cut-off frequency of the high-pass filter HPF becomes high when the degree of modulation is great (Fig. 14) or when the output of the multi-pass detector circuit is greater than a predetermined value (Fig. 15). Accordingly, the sensitivity of picking up the neighboring station signal interference is decreased, realizing reproduction of high fidelity like in the embodiments of Fig. 2 and 11.

The following effects are obtained from the aforementioned embodiments.

(1) Provision is made of a modulation degree detector circuit which monitors the modulation degree of demodulated audio signals from a desired station, and a wider band-pass characteristic is selected for the filter network when the modulation degree of audio signals becomes deeper than a predetermined modulation degree. Hence, the reproduction frequency band is broadened to realize reproduction of high fidelity.

(2) Addition of simply constructed circuits such as the modulation degree detector circuit and the gate circuit makes it possible to receive the broadcast excluding interference signals, taking the depth of modulation into consideration.

In the foregoing was concretely described the invention accomplished by the present inventors by way of embodiments. The invention, however, is in no way limited only to the above-mentioned embodiments but can be further modified in a variety of other ways without departing from the spirit and scope of the invention. For instance, a multiplexer can be provided in the input unit of the tracking filter circuit, so that the fixed input signal is selected to set the pass-band to a wider or the widest one by the output signal 11d of the modulation degree detector circuit. For instance, even in the case of overmodulation of about 150%, a nearly sufficient output signal can be reproduced if the band is of about the NC1. The holding circuit can be constituted by a counter circuit that counts the pulse signals in addition to being constituted by a time-constant circuit that is made up of a capacitor and a resistor.

The present invention can be widely utilized for FM radio receivers that employ a tracking filter circuit.

Briefly described below are the effects obtained by representatives of the inventions disclosed in this application. That is, provision is made of a modulation degree detector circuit and like circuits to monitor the modulation degree of modulated audio signals from a desired station, and a wider band-pass characteristic is selected for the filter network when the modulation degree of audio signals becomes deeper than a predetermined modulation degree, thereby to broaden the reproduction frequency band and to realize reproduction of high fidelity.

## Claims

1. A radio receiver comprising:
   a demodulator means (12) including a tracking filter (24) capable of switching a pass-band width;
   a filter control means (34) which controls the pass-band width of said tracking filter according to the strength of the electric field of the signal from a desired station and to the strength of the electric field of the signal from a neighboring station; and
   control circuits (11, 30, 31, 37, 38, 32) for controlling the operation of said filter control means.

2. A radio receiver according to claim 1, wherein
   said control means includes a modulation degree detector circuit (11) for controlling the degree of modulation of an audio signal demodulated from a signal of said desired station, and
   said modulation degree detector circuit (11) so controls the operation of said filter control means (34) that said tracking filter is made to have a wider pass-band width when said modulation degree detector circuit (11) detects that the degree of modulation of the audio signal demodulation from the signal of said desired station is greater than a predetermined degree of modulation.

3. A radio receiver according to claim 2, wherein
   said control means further includes first detector means (31, 32) that detect the strength of the electric field of the signal of a neighboring station, and
   when it is detected that the degree of modulation of the audio signal demodulated from the signal of said desired station is greater than a predetermined degree of modulation, said modulation degree detector circuit (11) substantially lowers the sensitivity of said first detector circuit, and thereby so controls the operation of said filter control means (34) that said tracking filter is made to have a wider pass-band width.

4. A radio receiver according to claim 2, wherein
   said control means further includes first detector means (31, 32) that detect the strength of the electric field of the signal of a neighboring station, and
   when it is detected that the degree of modulation of the audio signal demodulated from the signal of said desired station is greater than a predetermined degree of modulation, said modulation degree detector circuit (11) so controls the operation of said filter control means (34) that said tracking filter is made to have a wider pass-band width irrespective of the output signal of said first detector circuit.

5. A radio receiver according to claim 1, wherein

said control means includes first detector means (31, 32) for detecting the strength of the electric field of the signal of a neighboring station, and a multi-pass detector circuit (37) for detecting the phase difference between the signal of said desired station and a reflected wave related to the signal of said desired station and generating a multi-pass output signal corresponding thereto, and

when said multi-pass output signal becomes greater than a predetermined value, said multi-pass detector circuit (37) substantially lowers the sensitivity of said first detector circuit, and thereby so controls the operation of said filter control means (34) that said tracking filter has a wider pass-band width.

6. A radio receiver according to claim 1, wherein

said control means includes first detector (31, 32) for detecting the strength of the electric field of the signal of a neighboring station, a modulation degree detector circuit (11) for detecting the degree of modification of the audio signal demodulated from the signal of the neighboring station, and a multi-pass detector circuit (37) for detecting the phase difference between the signal of said desired station and a reflected wave related to the signal of said desired station and generating a multi-pass output signal corresponding thereto, and

when the modulation degree of the audio signal demodulated from the signal of said desired station is greater than a predetermined degree of modulation and when said multi-pass output signal is greater than a predetermined value, said control means substantially lowers the sensitivity of said first detector circuit and thereby so controls the operation of said filter control means (34) that said tracking filter has a wider pass-band width.

7. A radio receiver having a tracking filter function which automatically changes the band width according to the strength of the electric field of a desired station and to the strength of an electric field of a neighboring station, and comprising a modulation degree detector circuit which designates said filter network to change its band characteristic to a wider band characteristic when the degree of modulation of the demodulated audio signal of said desired station becomes deeper than a predetermined degree of modulation.

8. A radio receiver having a tracking filter function which automatically changes the band width according to the strength of the electric field of a desired station and to the strength of the electric field of a neighboring station, and comprising a modulation degree detector circuit which designates said filter network to change its band characteristic to the widest band characteristic when the degree of modulation of the demodulated audio signal of said desired station becomes deeper than a predetermined degree of modulation.

9. A radio receiver according to claim 7 or 8, wherein said radio receiver further comprises a control circuit which receives the output signal from said modulation degree detector circuit, and so control the filter network that the filter network does not change its band characteristic to any band characteristic except for the widest band characteristic when the degree of modulation becomes deeper than a predetermined degree of modulation and even when a strong interference signal is detected by the neighboring condition detector circuit.

10. A radio receiver having a tracking filter function which automatically changes the band width according to the strength of the electric field of a desired station and to the strength of the electric field of a neighboring station, wherein the sensitivity of a neighboring station pick-up circuit that detects the strength of the electric field of said neighboring station is substantially lowered when the degree of modulation of the demodulated audio signal of said desired station becomes deeper than a predetermined degree of demodulation and when the multi-pass signal becomes greater than a predetermined value.

11. A radio receiver according to claim 10, wherein said neighboring station pick-up circuit detects the envelop of envelope detection signal outputted from the tracking filter and does smoothing by causing the signal to pass through a high-pass filter, and the cut-off frequency of said high-pass filter is raised to substantially lower the sensitivity.

12. A radio receiver according to any one of claim 7, 8, 9, 10 and 11, wherein said modulation degree detector circuit has a holding circuit, and holds a detection output for a predetermined period of time when overmodulation is detected, and wherein the holding time is prolonged when overmodulation is detected again during the period in which the detection output is being held.

13. A radio receiver having a tracking filter function which automatically changes the band width according to the strength of the electric field of a desired station and to the strength of the electric field of a neighboring station, wherein the sensitivity of a neighboring station pick-up circuit that detects the strength of the electric field of said neighboring station is substantially lowered when the degree of modulation of the demodulated audio signal of said desired station becomes deeper than a predetermined degree of modulation or when a multi-pass signal becomes greater than a predetermined value.

# FIG. 1

HIGH-FREQUENCY SIGNAL AMPLIFIER CIRCUIT 3

FIRST MIXING CIRCUIT 5

FIRST INTERMEDIATE-FREQUENCY AMPLIFIER CIRCUIT 6

INTERMEDIATE-FREQUENCY FILTER (FIXED TYPE) 7

FIRST LOCAL OSCILLATION CIRCUIT 4

FIRST INTERMEDIATE-FREQUENCY AMPLIFIER STAGE

ADAPTIVE TRACKING FILTER FREQUENCY DEMODULATOR CIRCUIT

TRACKING FILTER CIRCUIT, ETC. 24

SECOND INTERMEDIATE-FREQUENCY SIGNAL DEMODULATOR UNIT 35

RECEIVING STATION SIGNAL LEVEL DETECTOR CIRCUIT 30

NEIGHBORING STATION SIGNAL LEVEL DETECTOR CIRCUIT 32

AND CIRCUIT 13

GATE CIRCUIT 14

PASS-BAND CONTROL CIRCUIT

(SECOND INTERMEDIATE-FREQUENCY AMPLIFIER STAGE) 12

MODULATION DEGREE DETECTOR CIRCUIT 11

FREQUENCY-MULTIPLEXED SIGNAL DEMODULATOR CIRCUIT 8

EP 0 567 265 A1

# FIG. 2

EP 0 567 265 A1

# FIG. 3

LEVEL

NC0

-3dB

NC1

NC2

NC3  F2 F1

NC4

0
CENTER FREQUENCY

FREQUENCY

# FIG. 4

STRONG

NEIGHBORING STATION
SIGNAL LEVEL

| | BAND NC4 | BAND NC4 | BAND NC4 18KHz |
|---|---|---|---|
| VT4 | BAND NC3 | BAND NC3 | BAND NC3 25KHz |
| VT3 | | | BAND NC2 25KHz |
| VT2 | BAND F2 23KHz | BAND F1 25KHz | BAND NC1 70KHz |
| VT1 | | | BAND NC0 BW(-3dB) 100KHz |

VT1          VT2          STRONG

RECEIVING STATION (DESIRED STATION)
SIGNAL LEVEL

## FIG. 5

LPF CHARACTERISTICS

-3dB

LEVEL

SECONDARY LPF

4KHz

MODULATION FREQUENCY CHARACTERISTICS

## FIG. 6

COMPARATOR CIRCUIT, HOLDING CIRCUIT

POSITIVE SIDE MODULATION
DEGREE DETECTION LEVEL

VOICE SIGNAL

NEGATIVE SIDE MODULATION
DEGREE DETECTION LEVEL

## FIG. 7

FORCED NCO MODE          FORCED NCO MODE

TA                    TA

NORMAL                NORMAL          TA
MODE                  MODE

OVERMODULATION DETECTED          OVERMODULATION DETECTED

OVERMODULATION DETECTED

# FIG. 8

EP 0 567 265 A1

## FIG. 9

## FIG. 10

NEIGHBORING STATION
SIGNAL LEVEL
DETECTOR CIRCUIT

GATE CIRCUIT

PASS-BAND
CONTROL
CIRCUIT

# FIG. 11

EP 0 567 265 A1

# FIG. 12

# FIG. 13

12dB/oct.

CHARACTERISTICS ARE
SHIFTED BY CURRENTS
Ia AND Ib

OUT

f₁  f₂  ( Hz )

# FIG. 14

EP 0 567 265 A1

## FIG. 15

FIRST i-f OUTPUT SIGNAL 7a

VOLTAGE-CONTROLLED ATTENUATOR 21 → 21a → SECOND MIXING CIRCUIT 23 → 23a → TRACKING FILTER CIRCUIT 24 → 24b → SECOND i-f SIGNAL DEMODULATOR CIRCUIT 25 → 25a → FREQUENCY CHARACTERISTICS COMPENSATION CIRCUIT 27 → MUTING CIRCUIT 28 → MPXOUT

SECOND INTERMEDIATE-FREQUENCY SIGNAL DEMODULATOR UNIT ~35

SECOND LOCAL OSCILLATION CIRCUIT 22, 22a, 24a

AGC SIGNAL 29a

AGC CIRCUIT 29
ENVELOPE DETECTOR CIRCUIT 29b
SMOOTHING CIRCUIT
29c, 29d

TRACKING CONTROL CIRCUIT 26, 26a

NEIGHBORING INTERFERENCE SOUND DETECTOR CIRCUIT 33
LPF 33a → INTERFERENCE SOUND LEVEL DETECTOR CIRCUIT 33b
33c

RECEIVING STATION SIGNAL LEVEL DETECTOR CIRCUIT 30 → 30a, 30b

PASS-BAND CONTROL CIRCUIT 34
34a, 34b, 34c, 34d

NEIGHBORING STATION PICK-UP CIRCUIT
HPF 31a → ENVELOPE DETECTOR CIRCUIT 31b → SMOOTHING CIRCUIT 31c → 31d ~31

GATE CIRCUIT 14, 14a-d, 32a-d

NEIGHBORING STATION SIGNAL LEVEL DETECTOR CIRCUIT 32

MULTI-PASS DETECTOR CIRCUIT ~37, 37a

MUTE DETECTOR CIRCUIT ~36

EP 0 567 265 A1

## FIG. 16

HIGH-FREQUENCY SIGNAL AMPLIFIER CIRCUIT — 3

FIRST MIXING CIRCUIT — 5

FIRST INTERMEDIATE-FREQUENCY AMPLIFIER CIRCUIT — 6

INTERMEDIATE-FREQUENCY FILTER (FIXED TYPE) — 7

ADAPTIVE TRACKING FILTER FREQUENCY DEMODULATION FILTER NETWORK — 102

FIRST LOCAL OSCILLATOR CIRCUIT — 4

FREQUENCY-MULTIPLEXED SIGNAL DEMODULATOR CIRCUIT — 8

101

102a

EP 0 567 265 A1

EP 0 567 265 A1

| European Patent Office | EUROPEAN SEARCH REPORT | Application Number |
|---|---|---|
| | | EP 93 30 2869 |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-4 356 568 (OGITA ET AL.) <br> * column 1, line 52 - column 2, line 23; figure 1 * <br> --- | 1 | H03G5/24 |
| A | CH-A-224 799 (N.V. PHILIPS' GLOEILAMPENFABRIEKEN) <br> * page 1, line 34 - page 2, line 9 * <br> --- | 2 | |
| A | EP-A-0 086 838 (OKI ELECTRIC INDUSTRY COMPANY LIMITED) <br> ----- | | |

TECHNICAL FIELDS
SEARCHED (Int. Cl.5 )

H03G
H03D
H04B

The present search report has been drawn up for all claims

| Place of search | Date of completion of the search | Examiner |
|---|---|---|
| THE HAGUE | 19 JULY 1993 | PEETERS M.M.G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04O1)